(19) Europäisches Patentamt

European Patent Office

Office européen des brevets

(11) **EP 1 607 886 A2**

(12) **EUROPEAN PATENT APPLICATION**

(43) Date of publication:
    **21.12.2005 Bulletin 2005/51**

(51) Int Cl.⁷: **G06F 17/50**

(21) Application number: **05012581.4**

(22) Date of filing: **10.06.2005**

(84) Designated Contracting States:
    **AT BE BG CH CY CZ DE DK EE ES FI FR GB GR
    HU IE IS IT LI LT LU MC NL PL PT RO SE SI SK TR**
    Designated Extension States:
    **AL BA HR LV MK YU**

(30) Priority: **16.06.2004  JP 2004178372**

(71) Applicant: **MATSUSHITA ELECTRIC INDUSTRIAL
    CO., LTD.**
    **Kadoma-shi, Osaka 571-8501 (JP)**

(72) Inventors:
    • **Takemura, Kazuyoshi**
      **Takatsuki-shi, Osaka 569-1018 (JP)**
    • **Shinohara, Katsuya**
      **Hirakata-shi, Osaka 573-0034 (JP)**

(74) Representative: **Grünecker, Kinkeldey,
    Stockmair & Schwanhäusser Anwaltssozietät
    Maximilianstrasse 58
    80538 München (DE)**

(54) **Design method and program for a bus control portion in a semiconductor integrated device**

(57)    According to a method for designing a semiconductor integrated device of the present invention, a simulation process (step S1) of the semiconductor integrated device is performed, and transaction data is stored in a transaction data storage process (step S2). Subsequently, the transaction data is analyzed in a transaction data analysis process (step S3), and a control portion for statically or dynamically controlling an optimal bit width, encoding method, operation frequency and so forth of the bus generated based on the analysis result is generated (step S4).

F I G.  1

```
        ┌──────────────────────────────┐
        │   START BUS ANALYSIS AND      │
        │   OPTIMIZATION PROCESS        │
        └──────────────┬───────────────┘
                       │
   S1 ┌────────────────▼───────────────┐
      │      SIMULATION PROCESS         │
      └────────────────┬───────────────┘
                       │
   S2 ┌────────────────▼───────────────┐
      │  TRANSACTION DATA STORAGE PROCESS│
      └────────────────┬───────────────┘
                       │
   S3 ┌────────────────▼───────────────┐
      │ TRANSACTION DATA ANALYSIS PROCESS│
      └────────────────┬───────────────┘
                       │
   S4 ┌────────────────▼───────────────┐
      │ CONTROL PORTION GENERATION PROCESS│
      └────────────────┬───────────────┘
                       │
        ┌──────────────▼───────────────┐
        │            END                │
        └──────────────────────────────┘
```

**EP 1 607 886 A2**

## Description

BACKGROUND OF THE INVENTION

Field of the Invention

The present invention relates to a design method, a design program, and a storage medium for a semiconductor integrated device. More specifically, the present invention relates to a design method, a design program, and a storage medium for a semiconductor integrated device, with which a mode and a configuration of a bus connecting between a plurality of functional blocks are analyzed.

Description of the Background Art

Semiconductor integrated devices that have been scaled-up and complicated in recent years and that are called a system LSI (large scale integration) are provided with a plurality of functional blocks, for example, processors such as a CPU and a DSP (digital signal processor), dedicated hardware for performing a specific process such as MPEG and JPEG, and memories. In many cases, an architecture (basic design) of the semiconductor integrated devices is such that a bus connects between these functional blocks. In the basic design of the semiconductor integrated devices, due to complicated congestion of data that is input/output into/from various blocks on the bus, the performance and the electric power consumption of the semiconductor integrated devices are significantly affected by the bus width, bus mode, and operation frequency. Accordingly, it is necessary to determine an optimal configuration and mode of a bus in the basic design of semiconductor integrated devices.

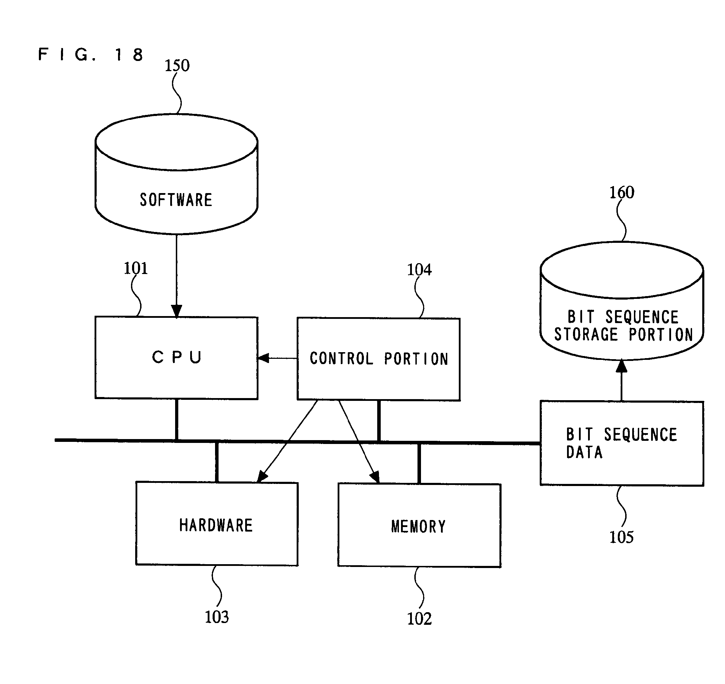

Conventionally, in determination of the configuration and the mode of a bus, an optimal bus width, bus encoding method, and operation frequency are determined based on information on simple bit strings running on the bus (see Japanese Laid-Open Patent Publication No. Hei 07-120532, for example). FIG. 18 is a conceptual diagram showing a conventional device for analyzing and optimizing a bus. In FIG. 18, a conventional technique optimizes the bus of an LSI that is configured by a CPU 101, software 150 operating on the CPU 101, a memory 102, and dedicated hardware 103. In this case, bit sequence data 160 configured from a bit sequence storage portion 105 in FIG. 18 is analyzed, a control portion 104 is configured based on the result, and the bus is thus optimized.

However, by the conventional method for designing a semiconductor integrated device, optimization is performed only locally because when the bit width, frequency, or encoding method of the bus for optimizing the performance and the electric power consumption is determined, the optimization is performed based on information on simple bit sequences.

SUMMARY OF THE INVENTION

Therefore, an object of the present invention is to provide a design method, a design program, and a storage medium for a semiconductor integrated device, that can optimize the configuration, mode, and operation frequency of a bus on the whole when determining the bus for optimizing the performance and the electric power consumption.

The present invention has the following features to attain the object mentioned above.

A first aspect of the present invention is directed to a method for designing a semiconductor integrated device by which a semiconductor integrated device having a bus connecting between functional blocks is designed. The method for designing a semiconductor integrated device includes a step of performing simulation that simulates an operation of the semiconductor integrated device, a step of classifying data bit sequences obtained in the step of performing simulation and running on the bus into at least one bit sequence having a meaning according to a protocol of the bus, and of storing the bit sequences as transaction data, and a step of analyzing the transaction data, and of generating a control portion for controlling the bus based on a predetermined condition.

In a second aspect based on the first aspect, in the step of storing transaction data, a transaction storage portion for extracting and storing the data bit sequences running on the bus according to the protocol as the transaction data is realized as hardware on the bus.

In a third aspect based on the first aspect, in the step of storing transaction data, a transaction storage portion for extracting and storing the data bit sequences running on the bus according to the protocol as the transaction data is realized as software that is executed by a central processing unit connected on the bus.

In a fourth aspect based on the first aspect, the step of generating a control portion includes the step of generating the control portion for determining a bus width of the bus based on the transaction data, and setting a selector for selecting the bus width.

In a fifth aspect based on the first aspect, the step of generating a control portion includes the step of generating the control portion for dynamically determining a bus width of the bus according to characteristics of the transaction data, and setting a selector for selecting the bus width.

In a sixth aspect based on the first aspect, in the step of generating a control portion, the control portion is generated to control the bus in such a manner that a bit string having a smallest change for each bit between sequential fixed-length bit strings in the transaction data is selected, the selected bit string in the transaction data is converted so as to minimize the change for each bit, and information for reconstructing the bit string before the conversion from the converted bit string is added.

In a seventh aspect based on the first aspect, in the step of generating a control portion, the control portion is generated to control the bus in such a manner that a bit string having a smallest change for each bit between sequential variable-length bit strings in the transaction data and a length of this bit string are selected, the selected bit string in the transaction data is converted with the length of the bit string so as to minimize the change for each bit, and information for reconstructing the bit string before the conversion from the converted bit string is added.

In an eighth aspect based on the seventh aspect, the control portion dynamically changes the length of the bit string according to characteristics of the transaction data.

In a ninth aspect based on the first aspect, in the step of generating a control portion, the control portion is generated to control the bus in such a manner that an appearance rate of each type of the transaction data is measured, a conversion table is created that converts a bit string in the transaction data whose appearance rate is comparatively high into a bit string smaller than the bit string is created, and the bit string in the transaction data is converted based on the conversion table.

In a tenth aspect based on the ninth aspect, the control portion dynamically changes the conversion table according to characteristics of the transaction data.

In an eleventh aspect based on the tenth aspect, the conversion table is implemented as software executed by the central processing unit connected on the bus, and the conversion table is dynamically changed by the software.

In a twelfth aspect based on the first aspect, in the step of generating a control portion, the control portion is generated to control the bus in such a manner that the transaction data is transmitted via a memory device having an input bus width and an output bus width that are different from each other, according to the transaction data.

In a thirteenth aspect based on the twelfth aspect, the control portion dynamically changes at least one of the input bus width and the output bus width according to characteristics of the transaction data.

In a fourteenth aspect based on the first aspect, in the step of generating a control portion, the control portion is generated to control the bus in such a manner that according to characteristics of the transaction data, a frequency dividing circuit is controlled to dynamically change an operation frequency.

A fifteenth aspect of the present invention is directed to a program for designing a semiconductor integrated device with which a semiconductor integrated device having a bus connecting between functional blocks is designed and that is executed by a computer.

The design program lets the computer execute a step of performing simulation that simulates an operation of the semiconductor integrated device, a step of classifying data bit sequences obtained in the step of performing simulation and running on the bus into at least one bit sequence having a meaning according to a protocol of the bus, and of storing the bit sequences as transaction data, and a step of analyzing the transaction data, and of generating a control portion for controlling the bus based on a predetermined condition.

A sixteenth aspect of the present invention is directed to a storage medium for storing a program for designing a semiconductor integrated device with which a semiconductor integrated device having a bus connecting between functional blocks is designed and that is executed by a computer. The design program lets the computer execute a step of performing simulation that simulates an operation of the semiconductor integrated device, a step of classifying data bit sequences obtained in the step of performing simulation and running on the bus into at least one bit sequence having a meaning according to a protocol of the bus, and of storing the bit sequences as transaction data, and a step of analyzing the transaction data, and of generating a control portion for controlling the bus based on a predetermined condition.

With the method for designing a semiconductor integrated device of the present invention, a bit sequence having regularity, similarity and a meaning is treated as transaction, and thus it is possible to optimize the configuration, mode, and operation frequency of the bus on the whole according to types of transaction transfer to achieve the effect such as optimization of the performance and reduction in the electric power consumption of the semiconductor integrated device.

Furthermore, with the program for designing a semiconductor integrated device and the storage medium for storing the design program of the present invention, the same effect as in the method for designing a semiconductor integrated device can be achieved.

These and other objects, features, aspects and advantages of the present invention will become more apparent from the following detailed description of the present invention when taken in conjunction with the accompanying drawings.

BRIEF DESCRIPTION OF THE DRAWINGS

FIG. 1 is a flowchart showing an outline of a method for designing a semiconductor integrated device according to an embodiment of the present invention;
FIG. 2 is an example of transaction data used in the method for designing a semiconductor integrated device in FIG. 1;
FIG. 3 is an example of a device in which a transaction storage portion 5 that is realized by hardware and that stores transaction data 60 is configured on a bus of the system;

FIG. 4 is an example of a device configured on a bus of the system with software 50 including a transaction API 5;

FIGS. 5A through 5D are conceptual diagrams showing the size and the electric power consumption of data running on a bus;

FIG. 6 is an example of a circuit for selecting an optimal bus width;

FIG. 7 is another example of a circuit for selecting an optimal bus width;

FIG. 8 is an example of a circuit for optimizing the electric power consumption by using a transformation function;

FIG. 9 is an example of a circuit for optimizing the electric power consumption by using a transformation function that utilizes fixed-length bit inversion;

FIGS. 10A and 10B are diagrams showing the relationship between fixed-length bit inversion and the toggle count;

FIGS. 11A and 11B are diagrams showing the relationship between variable-length bit inversion and the toggle count;

FIG. 12 is an example of a circuit for optimizing the electric power consumption by performing transfer with a smaller number of bits;

FIG. 13 is a diagram showing examples in which transaction data T that can be decoded is encoded for reducing traffic;

FIG. 14 is a block diagram of a device in which transaction is transferred via a memory portion 13 having an input bus width BW1 and an output bus width BW2;

FIG. 15 is an example of a semiconductor integrated circuit device for optimizing the electric power consumption of a bus by lowering the operation frequency;

FIG. 16 is an example of a master clock control portion 14m for dynamically changing a clock by hardware;

FIG. 17 is an example of a master clock control portion 14m for dynamically changing a clock by software; and

FIG. 18 is a conceptual diagram showing a conventional device for analyzing and optimizing a bus.

DESCRIPTION OF THE PREFERRED EMBODIMENTS

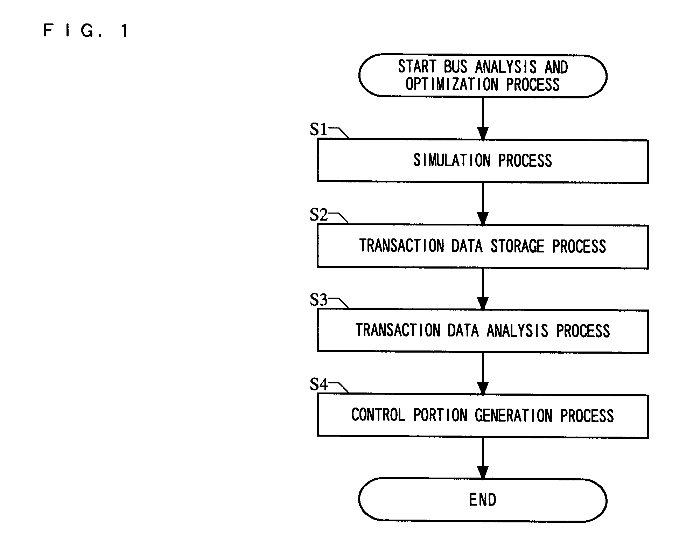

Hereinafter, a method for designing a semiconductor integrated device according to an embodiment of the present invention will be described with reference to the drawings. First, referring to FIG. 1, an outline of this method for designing a semiconductor integrated device will be described. FIG. 1 is a flowchart showing an outline of this method for designing a semiconductor integrated device.

In FIG. 1, by the method for designing a semiconductor integrated device to which the present invention is applied, a simulation process (step S1) of simulating an operation of the semiconductor integrated device is performed. Next, in a transaction data storage process (step S2), a data bit sequence obtained in the simulation process and running on a bus that connects between functional blocks of the semiconductor integrated device is stored according to the protocol of the bus as transaction data (described below) that is a plurality of or a single bit sequence having a meaning. Subsequently, in a transaction data analysis process (step S3), the transaction data is analyzed, and a control portion for statically or dynamically controlling an optimal bit width, encoding method, operation frequency and so forth of the bus generated based on the analysis result is generated (step S4).

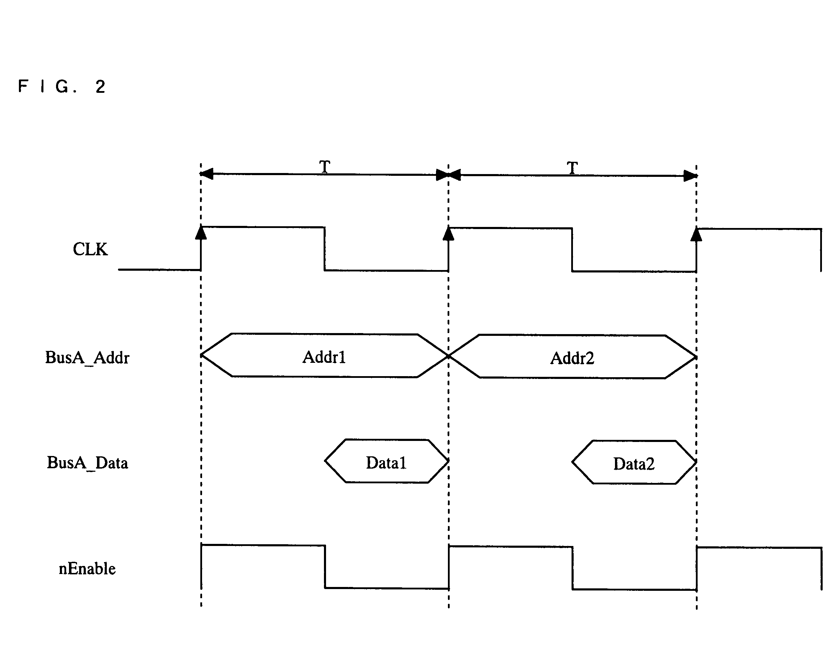

Next, referring to FIG. 2, the transaction data used in the method for designing a semiconductor integrated device will be described. FIG. 2 is a diagram showing an example of such transaction.

In FIG. 2, transaction of the present invention is a series of bit sequences. The bus is configured by, for example, a clock CLK, an address signal BusA_Addr showing an address, BusA_Data showing data, and nEnable showing that the data is valid. In this case, a collection of control signals such as a clock CLK, an address BusA_Addr, data BusA_Data, and nEnable is treated as the transaction T in the present invention.

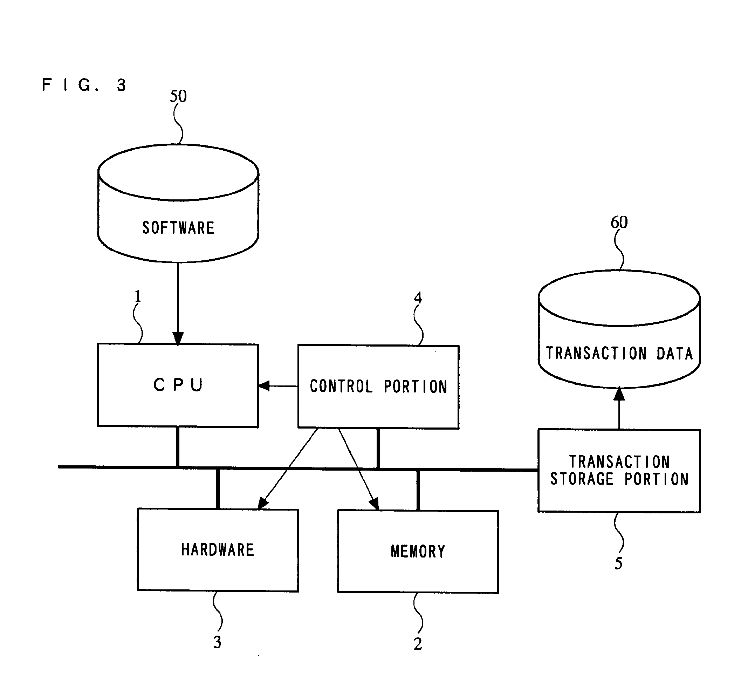

FIG. 3 is an example of a device in which a transaction storage portion 5 for storing transaction data 60 is configured on a bus of the system according to the present invention. The system provided with the device is configured by a CPU 1, software 50 operating on the CPU 1, a memory 2, dedicated hardware 3, a control portion 4 for controlling the bus. In the simulation process in step S1 described above, the transaction storage portion 5 monitors the bus and extracts transaction according to the bus protocol. The transaction that has been extracted is stored in the transaction data 60 from the transaction storage portion 5 in the transaction data storage process in step S2 described above.

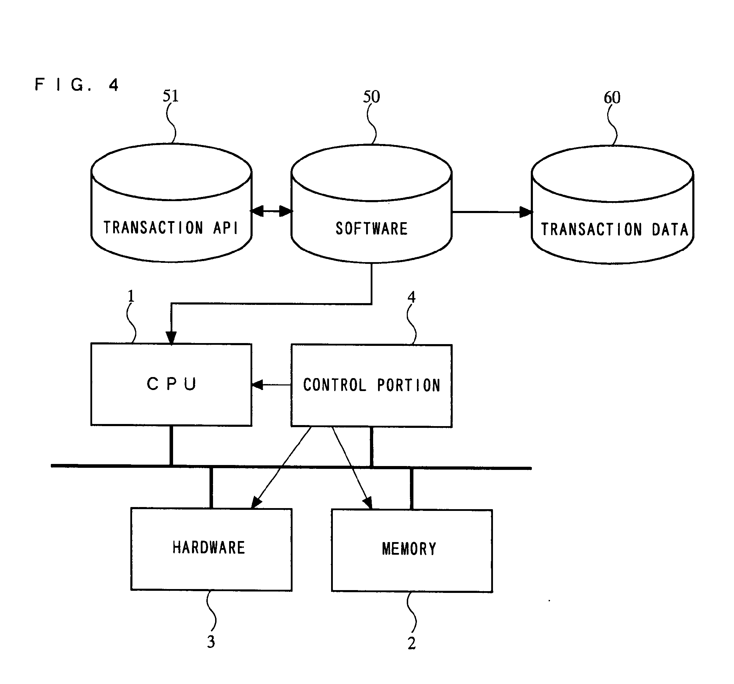

In the device shown in FIG. 3, the transaction is extracted from data running on the bus according to the bus protocol, but it is also possible to extract and store the transaction data 60, instead of monitoring the bus, by letting the software 50 operating on the CPU 1 include a transaction API (application program interface) 51 for storing the transaction. FIG. 4 is an example in which the present invention is realized by the software 50 including the transaction API 51.

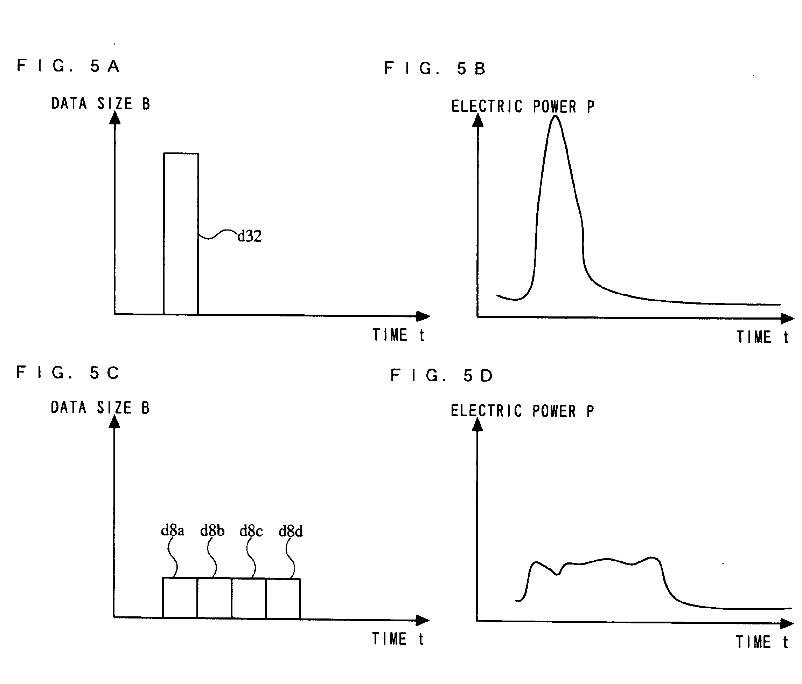

Herein, the relationship between the size and the electric power consumption of data running on the bus will be described. FIGS. 5A through 5D are diagrams showing the size and the electric power consumption of data running on the bus. FIG. 5A shows that one set of 32-bit data d32 has run on the bus, and FIG. 5B shows an electric power P at that time. As shown in FIGS. 5A and 5B, when 32-bit data d32 is transferred to one bus all at once, the peak electric power value of the electric power P increases. On the other hand, FIG. 5C shows that one set of 32-bit data is divided into four sets of 8-bit data d8a to d8d and is transferred to the bus, and FIG. 5D shows an electric power P at that time. As shown in FIGS. 5C and 5D, although the total amount of electric power consumption for data transfer does not change significantly, dividing data can suppress the peak electric power value of the electric power P.

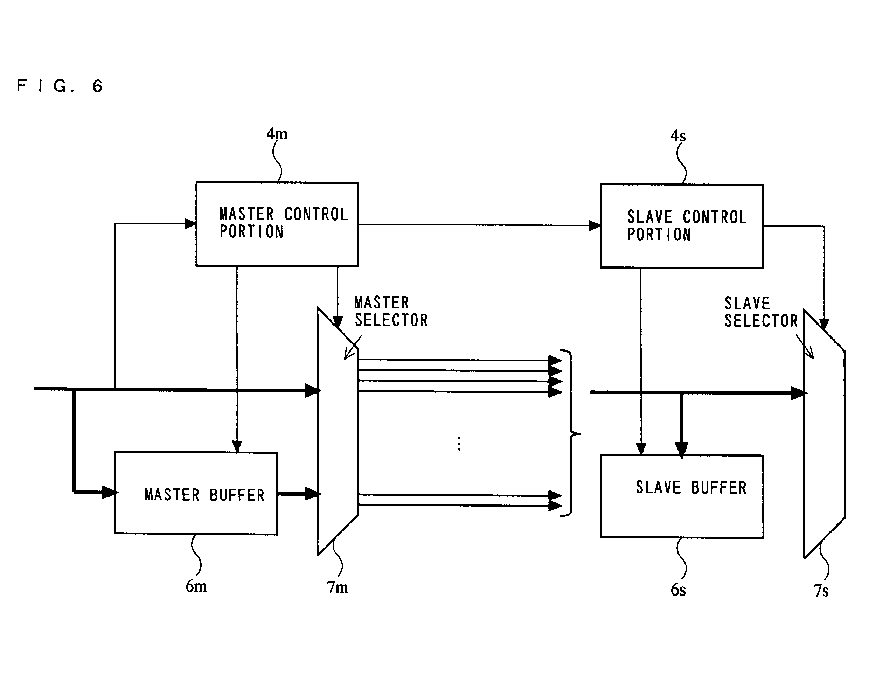

FIG. 6 is an example of a circuit including the control portion 4 for selecting an optimal bus width with respect to the above-described electric power consumption. When the transaction data that has been stored in the transaction data storage process (step S2) shown in FIG. 1 is analyzed in the transaction data analysis process (step S3), the combination of transaction causing the peak electric power of the bus is clarified. In the case where the size of the transaction data is comparatively large, and the performance is satisfied even when the data is divided, it is possible to suppress the peak electric power value by performing data division (see FIGS. 5A through 5D). It should be noted that whether or not the performance is satisfied can be determined by analyzing the result obtained by performing again the simulation process (step S1) under a condition where transaction having divided data is generated.

In order to realize the data division described above, the circuit including the control portion 4 of this embodiment is configured by a master control portion 4m, a slave control portion 4s, a master buffer 6m, a slave buffer 6s, a master selector 7m, and a slave selector 7s on the bus. When data is divided as a result of the transaction data analysis process in step S3 described above, the master control portion 4m stores the data in the master buffer 6m for temporarily storing divided data. Subsequently, the master control portion 4m transfers the data stored in the master buffer 6m sequentially to the slave buffer 6s via the master selector 7m. When the slave side receives the data, if information for reconstructing one set of data from the divided and sent data is sent from the master control portion 4m to the slave control portion 4s, the slave control portion 4s reconstructs the data according to this information at the slave buffer 6s. Furthermore, in the case where the master control portion 4m does not change the data size, the present invention is realized when the undivided data is transferred to the slave side via the master selector 7m and selected by the slave selector 7s. It should be noted that the present invention also encompasses a method by which first data is divided by a selector and directly transferred in order to reduce overhead in division uniting.

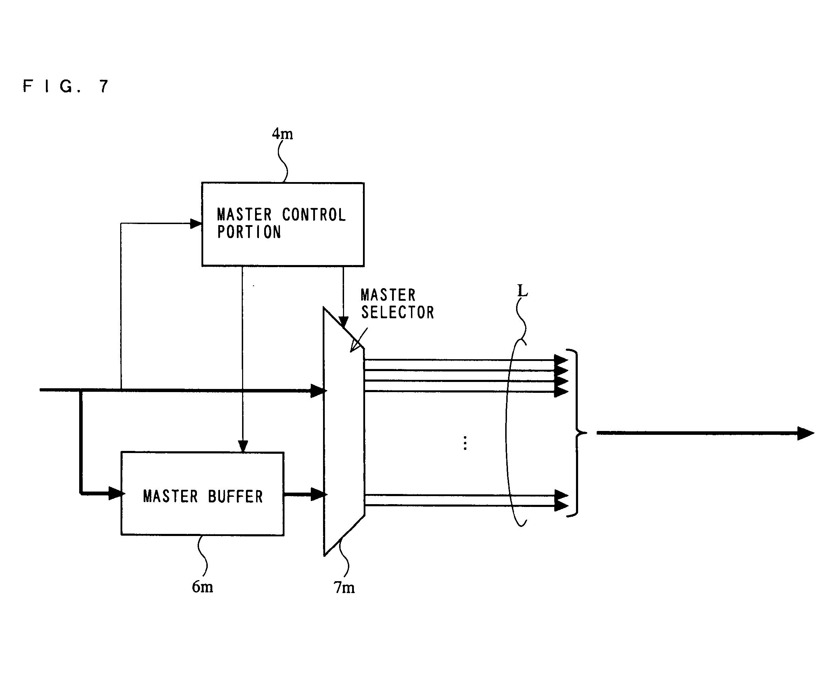

As shown in FIG. 7, in the case where signal lines L showing the size and the bit position of data are included in the bus, the slave control portion 4s, the slave selector 7s, and the slave buffer 6s shown in FIG. 6 become unnecessary. Furthermore, in the case where at least one of the size and the bit position of data is determined by the protocol, the present invention can be realized by a similar circuit configuration based on the remaining information, and thus the present invention can be applied in a similar manner. When the size and the bit position of data that is to be transferred are controlled by the master control portion 4m and selected by the master selector 7m, the circuit in FIG. 6 can be realized more easily.

As a method for estimating the electric power consumption of the semiconductor integrated circuit, a method is generally known by which a netlist at the gate level of the circuit of interest is simulated, and the toggle count at the gate output in the simulation is counted. In the case of a bus, the above-descried count can be obtained based on the toggle count of data. Since the electric power consumption increases in proportion to the toggle count, the electric power consumption of the bus can be optimized by reducing the toggle count.

In order to minimize the toggle count at the bus, a transformation function is used in Formula (1) below is minimized for which a transaction sequence $Tr=\{T_1, T_2, ..., T_n\}$, so that the electric power consumption of the bus is optimized.

<div align="center">

Formula (1)

$$\Sigma d_H(T_{i-1}, \text{transformation function}(T_i))$$

</div>

where $d_H(\alpha, \beta)$ is the Hamming distance between $\alpha$ and $\beta$, and refers to the toggle count.

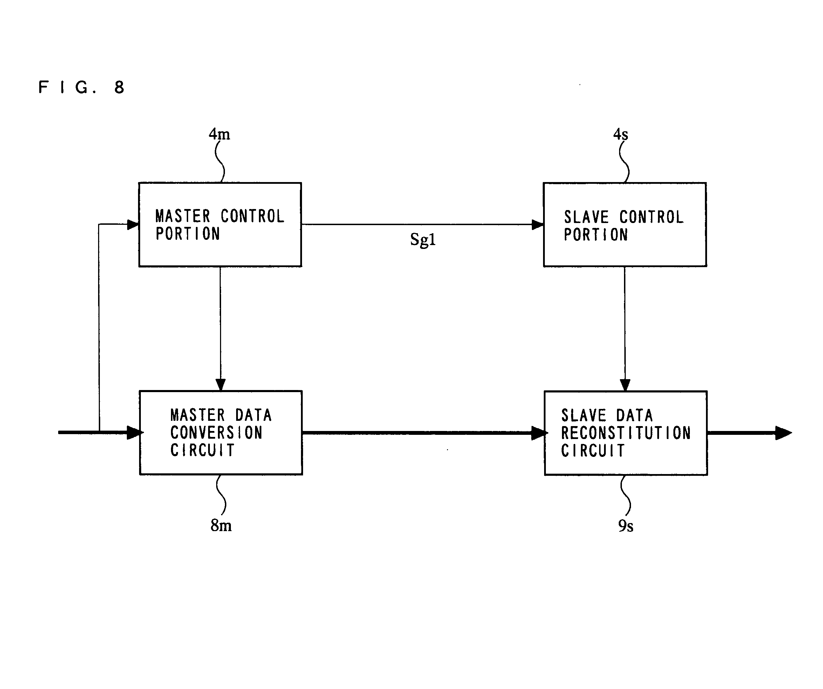

FIG. 8 is an example of a circuit including the control portion 4 for optimizing the electric power consumption by using the transformation function. In order to utilize the Hamming distance $d_H(T_{i-1}, \text{transformation function}(T_i))$ using the previous transaction $T_{i-1}$ and the transformation function of the transaction $T_i$, which is to be sent, shown in FIG. 1, it is necessary also for the slave side to have this transformation function. Based on the result of the transaction data analysis process in step S3 described above, a transformation function in which Formula (1) comes first is selected. In FIG. 8, a master data conversion circuit 8m realizes the transformation function. At that time, information for reconstruction is necessary on the slave side, and thus the master control portion 4m sends reconstruction information Sg1 that is information for reconstruction to the slave control portion 4s. The slave control portion 4s sends the received reconstruction information Sg1 to a slave data reconstruction circuit 9s, and the data that has been sent from the master data conversion circuit 8s is reconstructed at the slave data reconstruction circuit 9s. With this circuit configuration, the electric power consumption of the bus is optimized.

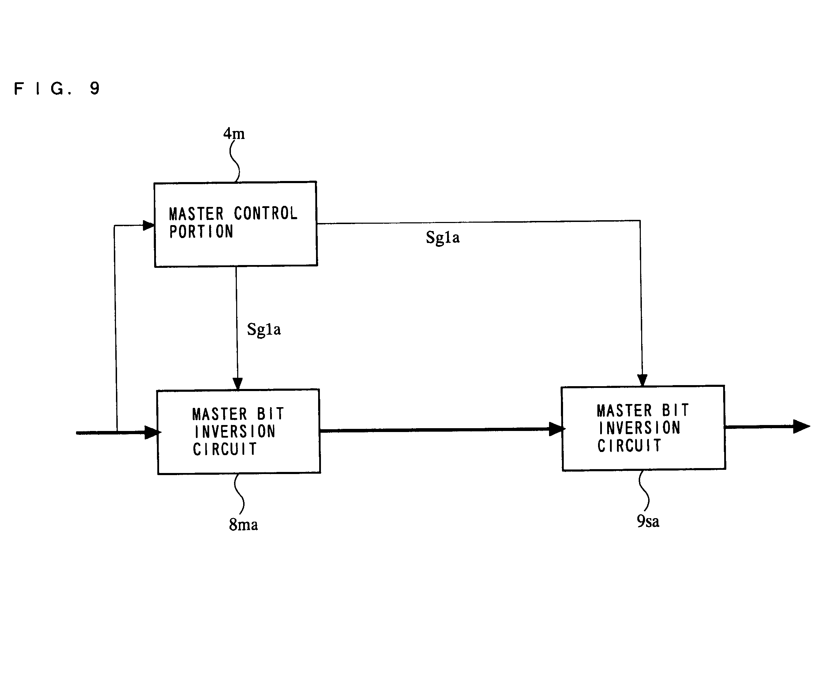

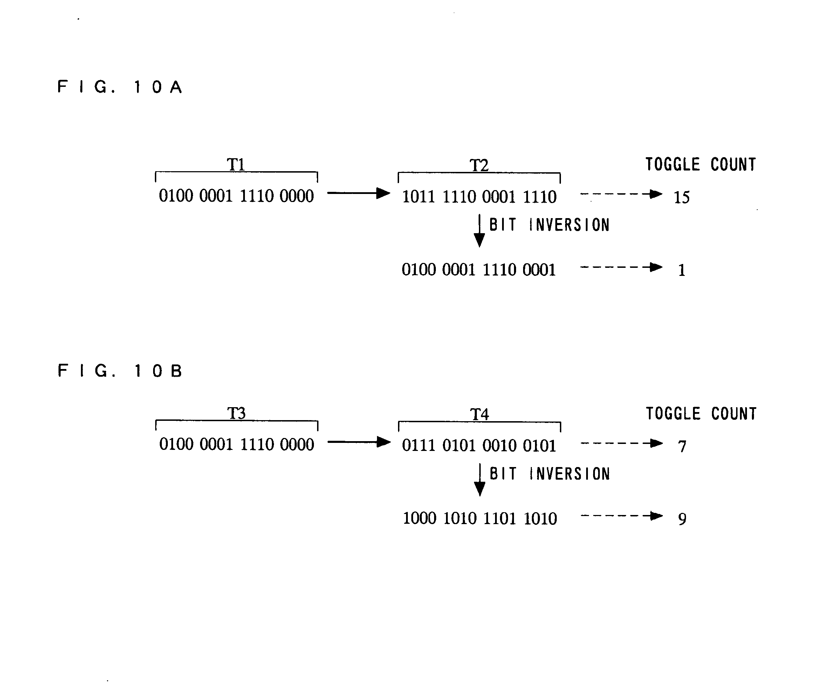

Referring to FIGS. 9, 10A and 10B, an example will be described in which fixed-length bit inversion is utilized with the transformation function. FIG. 9 is an example of a circuit including the control portion 4 for optimizing the electric power consumption by using a transformation function that utilizes fixed-length bit inversion. FIGS. 10A and 10B are diagrams showing the relationship between fixed-length bit inversion and the toggle count.

As shown in FIG. 10A, when after previous transaction data T1 "0100 0001 1110 0000" is sent, next transaction data T2 "1011 1110 0001 1110" is sent as it is, the toggle count is 15. In this case, if bit inversion is performed on the transaction data T2, the transaction data T2 is "0100 0001 1110 0001". With this bit inversion, an inversion signal increases by 1 bit between the master and the slave, but the toggle count of the transaction is 1.

Furthermore, as shown in FIG. 10B, when after previous transaction data T3 "0100 0001 1110 0000" is sent, next transaction data T4 "0111 0101 0010 0101" is sent as it is, the toggle count is 7. If bit inversion is performed on the transaction data T4, the transaction data T4 is "1000 1010 1101 1010", and the toggle count after the bit inversion is 9. Thus, in this case, when the data is sent as it is without bit inversion, the toggle count can be suppressed to the number of transmission bits or less.

Herein, whether or not transaction data is suitable for bit inversion with the transformation function is determined in the transaction data analysis process in step S3 described above. More specifically, in FIG. 9, the master control portion 4m possesses previous transaction data, and calculates the Hamming distance between the previous transaction and transaction that is to be sent next. If the Hamming distance is comparatively large, in order to perform the fixed-length bit inversion on the transfer data, bit inversion direction signals Sg1a from the master control portion 4m to a master bit inversion circuit 8ma and a slave bit inversion circuit 9sa are made active. The bit inversion circuit 8ma performs bit inversion on the transaction data that is to be sent and sends out the data to the slave bit inversion circuit 9sa. The slave bit inversion circuit 9sa processes the received data according to the bit inversion direction signal Sgla.

In the above explanation, the transformation function only is implemented by hardware, but it is possible to utilize the transformation function by incorporating the transaction API 51 (see FIG. 4) into the software 50 operating on the CPU 1. In the case where the software 50 operating on the CPU 1 transfers data by using the transaction API 51, if a transformation function that is optimal for the transaction is selected inside the transaction API 51, and a request to use the transformation function is sent from the inside of the transaction API 51 to the control portion 4, it is possible to dynamically select a transformation function by using the software 50. When a dynamic conversion function is implemented in each of the master control portion 4m and the slave control portion 4s, the function can be realized.

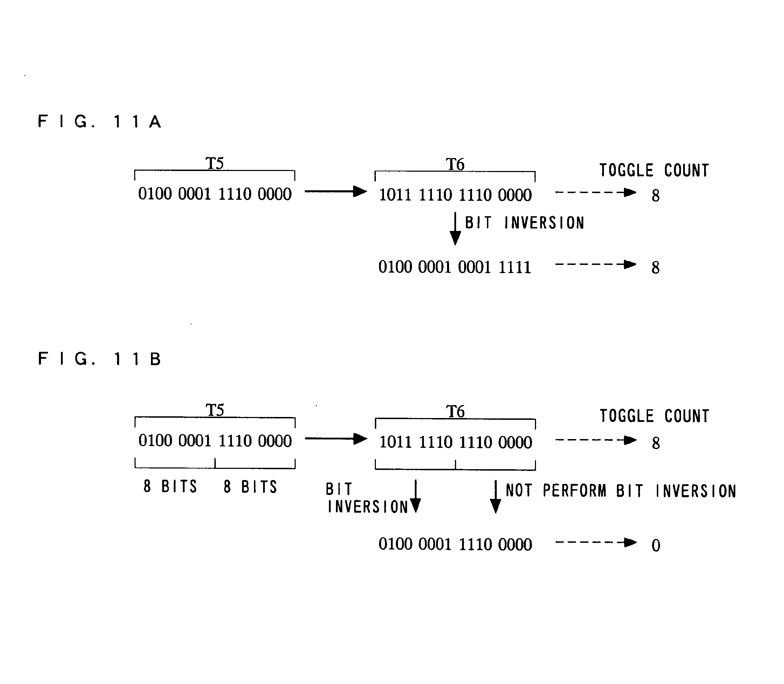

Next, referring to FIGS. 11A and 11B, an example will be described in which variable-length bit inversion is utilized with the transformation function. FIGS. 11A and 11B are diagrams showing the relationship between variable-length bit inversion and the toggle count.

As shown in FIG. 11A, when after previous transaction data T5 "0100 0001 1110 0000" is sent, next transaction data T6 "1011 1110 1110 0000" is sent as it is, the toggle count is 8. If bit inversion is performed on the entire transaction data T6, the transaction data T6 is "0100 0001 0001 1111", the toggle count with this bit inversion is 8, and in addition, an inversion signal increases by 1 bit between the master and the slave. More specifically, in this case, it is better to perform transfer without bit inversion, because the toggle count does not change and the inversion signal increases by 1 bit with the inversion.

However, as shown in FIG. 11B, the transaction data T6 that is configured by a 16-bit string is divided into 8-bit data, and the first-half bit string is inverted and the second-half bit string is not inverted, the toggle count decreases from 8 to 0. Herein, when the data is divided into 8-bit data, 1 bit for information showing that bit division has been performed and 2 bits for information showing whether or not the inversion is performed, that is, 3 bits in total are additionally necessary.

Herein, whether or not with the transformation function, bits of transaction data should be divided and whether or not bit inversion should be performed on each divided group are determined in the transaction data analysis process in step S3 described above. More specifically, in FIG. 9, the master control portion 4m possesses previous transaction data, and divides the previous transaction and transaction that is to be sent next into a plurality of bit widths, and the Hamming distance based on each division is calculated. Then, the master control portion 4m selects the division with which the Hamming distance becomes the smallest. When the division method is determined, if the Hamming distance for a divided group is comparatively large, in order to perform bit inversion on the transfer data, the bit inversion direction signals Sg1a from the master control portion 4m to the master bit inversion circuit 8ma and the slave bit inversion circuit 9sa are made active. The bit inversion circuit 8ma performs bit inversion on the transaction data that is to be sent and sends out the data to the slave bit inversion circuit 9sa. The slave bit inversion circuit 9sa processes the received data according to the bit inversion direction signal Sgla.

In the above explanation, the transformation function is implemented only by hardware, but it is possible to utilize the transformation function by incorporating the transaction API 51 (see FIG. 4) into the software 50 operating on the CPU 1. In the case where the software 50 operating on the CPU 1 transfers data by using the transaction API 51, if a transformation function that is optimal for the transaction is selected inside the transaction API 51, and a request to use the transformation function is sent from the inside of the transaction API 51 to the control portion 4, it is possible to dynamically select a transformation function by using the software 50. When a dynamic conversion function is implemented in each of the master control portion 4m and the slave control portion 4s, the function can be realized.

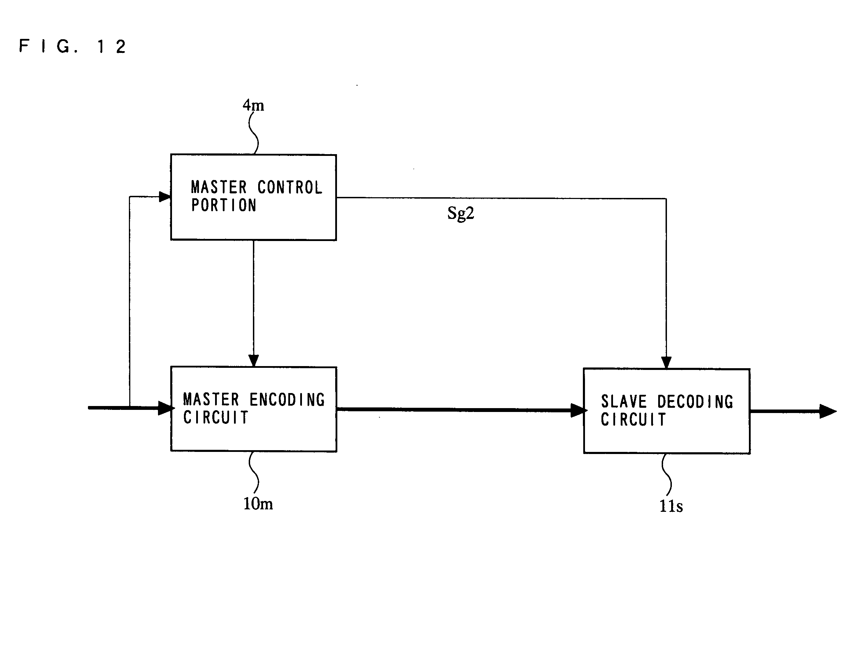

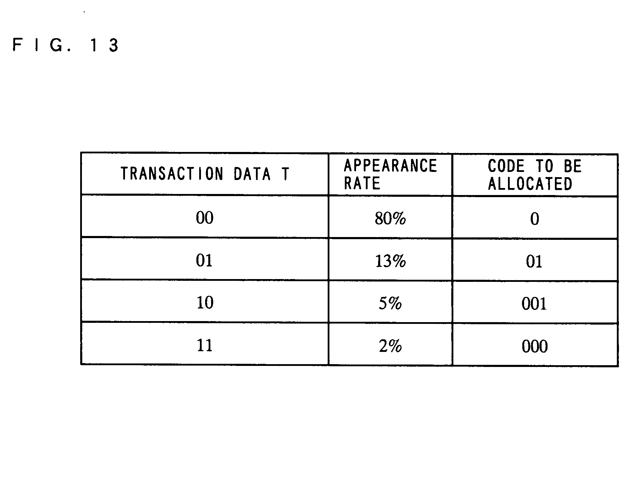

Furthermore, as another measure for optimizing the electric power consumption of a bus, a measure is conceivable in which the amount of data that is transferred via the bus is reduced. Referring to FIGS. 12 and 13, an example will be described in which with respect to transaction data, the entire transaction is transferred with a smaller number of bits. FIG. 12 is an example of a circuit including the control portion 4 for optimizing the electric power consumption by performing the transfer with a smaller number of bits. FIG. 13 is a diagram showing an example in which transaction data T that can be decoded is encoded for reducing traffic.

The examples of transaction data T shown in FIG. 13 all have the code length of 2, and there is a specific bias in the appearance rate of the data. More specifically, the appearance rate at which the transaction data T is "00" is 80%. The appearance rate at which the transaction data T is "01" is 13%. The appearance rate at which the transaction data T is "10" is 5%. The appearance rate at which the transaction data T is "11" is 2%.

At that time, codes shown in FIG. 13 are allocated to each of the transaction T. More specifically, the 1-bit code "0" is allocated to the transaction data T that is "00". The 2-bit code "01" is allocated to the transaction data T that is "01". The 3-bit code "001" is allocated to the transaction data T that is "10". The 3-bit code "000" is allocated to the transaction data T that is "11". The transfer amounts before and after the encoding process in this example are 2 bits×100% : 1 bit×80% + 2 bits×13% + 3 bits×5% + 3 bits×2% = 200 : 127, and thus the data amount is reduced by close to about 40%. As a result, the electric power consumption is reduced.

In FIG. 12, a master encoding circuit 10m perform the encoding process and transfers the data to a slave decoding circuit 11s, and a circuit that is optimal for sending transaction with respect to the data amount is thus configured. An optimal encoding method is determined based on the result of the transaction data analysis process in step S3 described above, and then the master control portion 4m creates a conversion table (see FIG. 13, for example) based on the encoding method. The master encoding circuit 10m and the slave decoding circuit 11s respectively perform an encoding process and a decoding process based on the conversion table.

At that time, in the case where transaction is not data used in step S1 described above, there is a possibility that an optimal encoding process is not performed with the conversion table. It is possible to dynamically change the conversion table to create an optimal conversion table when the software 50 (see FIG. 4) that operates on the CPU 1 and that uses the transaction API 51 calculates an optimal encoding at the time of starting data transfer, creates a new conversion table, and then transfers the conversion table to the master control portion 4m. Furthermore, the present invention can be realized also by preparing a plurality of kinds of conversion tables in advance and by switching them in the case where all processes of changing a conversion table are realized by software or in the case where an impact on the performance is significant, and the present invention also encompasses such method for changing a conversion table.

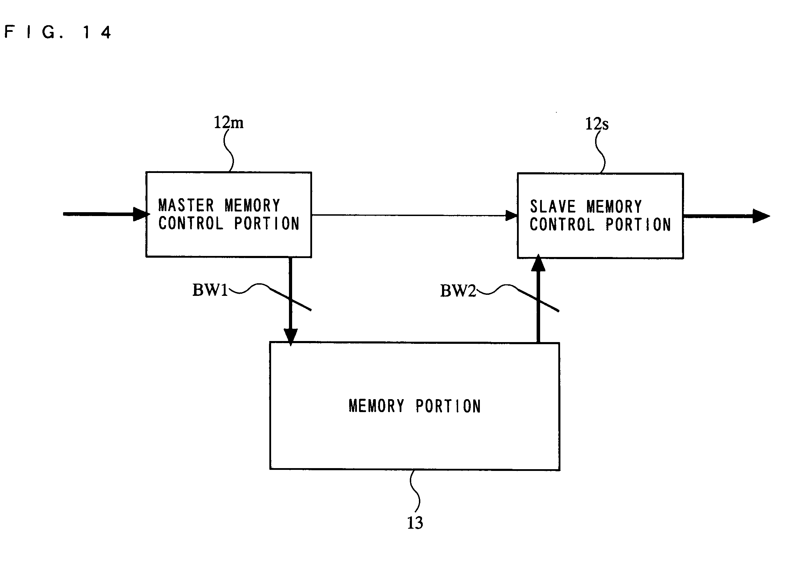

Next, referring to FIG. 14, an example of a device will be described in which transaction is transferred via a memory portion having bus widths that are different for an input port and for an output port. FIG. 14 is a block diagram of a device in which transaction is transferred via a memory portion 13 having an input bus width BW1 and an output bus width BW2.

In FIG. 14, the slave side can utilize data stored in the memory portion 13 at a desired timing when a buffer is not provided at either of the input port and the output port, but the ports are respectively provided with a master memory control portion 12m and a slave memory control portion 12s and share the memory portion 13. Regarding an optimal timing for both of the master side and the slave side, a timing at which data is necessary is analyzed based on the performance analysis in the transaction data analysis process in step S3 described above, and if there is some time left before that timing, the relationship (see FIGS. 5A through 5D) between the size and the electric power consumption of the data is taken into consideration, and thus the component circuit shown in FIG. 14 is used to optimize the bus. It is also possible to dynamically change the bit width by combining the configuration shown in FIG. 6 or 7 into the component circuit shown in FIG. 14. There are methods for controlling a change in the bus width by hardware and software, and both of them are examples of a circuit configured based on the present invention. In this embodiment, the memory device has been described with reference to the memory portion 13, but the memory device in the sense of the present invention includes a register, an FIFO and similar devices. Also, in FIG. 14, different ports are formed on the memory portion 13, but it is also possible that the master side and the slave side use a common port.

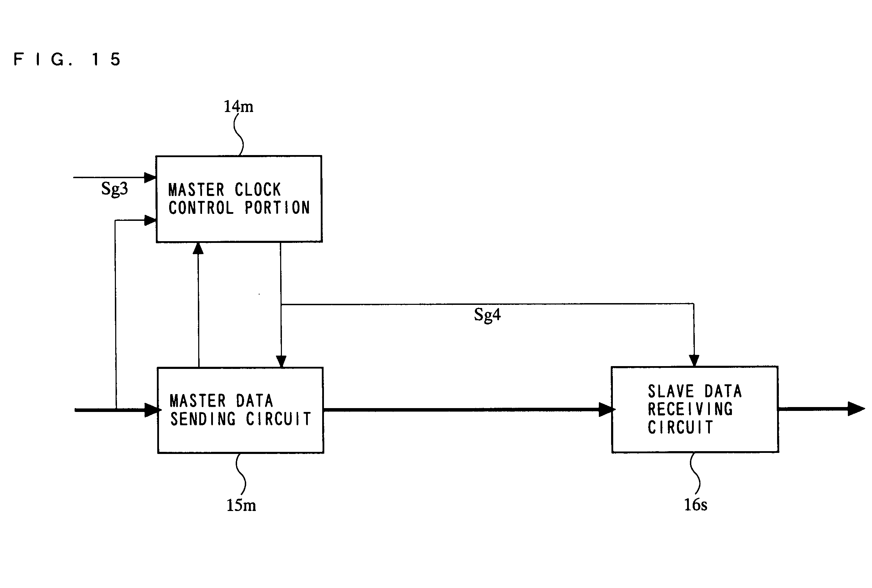

In addition, as another measure for optimizing the electric power consumption of a bus, a measure is conceivable that lowers the operation frequency. Referring to FIG. 15, an example will be described in which by lowering the operation frequency, the electric power consumption of a bus is optimized. FIG. 15 is an example of a semiconductor integrated circuit device that dynamically changes the operation frequency.

In FIG. 15, a master clock control portion 14m transmits a clock obtained by changing the clock cycle of an input clock signal Sg3 serving as the base or the identical clock thereto, as a clock signal Sg4, to a master data sending circuit 15m and a slave data receiving circuit 16s. The master data sending circuit 15s and the slave data receiving circuit 16s that have received the clock signal Sg4 operate in accordance with the cycle of the clock signal Sg4 with which the circuits operate.

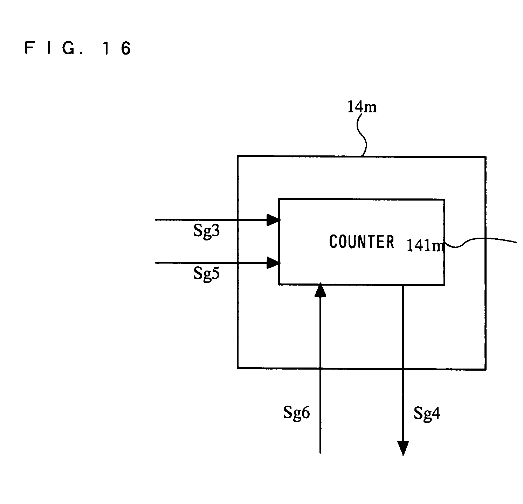

FIG. 16 shows an example of the master clock control portion 14m that dynamically changes a clock only by hardware. In FIG. 16, the master clock control portion 14m includes a counter 141m. The master clock control portion 14m can divide the frequency for the base counter value set at the counter 141m. In the case where the dividing is not performed, the master clock control portion 14m can output the input clock signal Sg3 as it is.

When transfer is started, a transaction transfer starting signal Sg5 is sent to the master clock control portion 14m via the bus. Even without the use of the transaction transfer starting signal Sg5, transaction is generated from the bus in the configuration similar to that in the method used in the transaction storage portion 5 (see FIG. 3), and thus this configuration may be used. When the transaction transfer starting signal Sg5 is sent, the master clock control portion 14m can increase the operation frequency by reducing the base counter value obtained by referring to the counter 141m. When a master transaction transfer ending signal Sg6 is detected from the bus, the master clock control portion 14m can lower the frequency by increasing the base counter value of the counter 141m. In this manner, the master clock control portion 14m changes the frequency in accordance with an increase or a decrease of transaction, and thus an optimal frequency is dynamically selected.

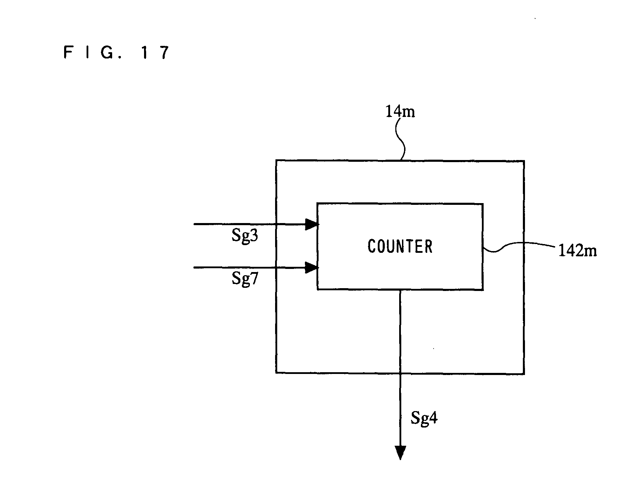

FIG. 17 shows an example of the master clock control portion 14m that realizes means for changing the frequency with software. In FIG. 17, a counter 142m is formed in the master clock control portion 14m.

With the use of the transaction API 51 (see FIG. 4) that is used with the software 50 that operates on the CPU 1, when the transfer start is notified to the control portion 4 in prior to the transaction start, the master clock control signal Sg7 that is to be input to the master clock control portion 14m in FIG. 17 is changed. More specifically, the master clock control signal Sg7 plays a role similar to that of the master transaction transfer starting signal Sg5 (see FIG. 16), and with this configuration, it is possible to configure a circuit in which the master clock portion 14m dynamically changes the clock frequency in a similar manner.

The example in FIG. 17 shows that the master clock control signal Sg7 to the master clock control portion 14m is generated via the control portion 4, but it is also possible to control the master clock control portion 14m directly by the CPU 1 with software, and the circuit can be configured in this manner.

The above-described method for designing a semiconductor integrated device also can be realized as a program for designing a semiconductor integrated device that lets a computer execute each of the steps. Furthermore, the design program can be stored onto a storage medium (optical disk, magnetic disk, memory card, for example) that can be read by the computer. In addition, the design program can be supplied via other media or communication lines.

While the invention has been described in detail, the foregoing description is in all aspects illustrative and not restrictive. It is understood that numerous other modifications and variations can be devised without departing from the scope of the invention.

**Claims**

1. A method for designing a semiconductor integrated device by which a semiconductor integrated device having a bus connecting between functional blocks is designed, comprising:

   a step (S1) of performing simulation that simulates an operation of the semiconductor integrated device,
   a step (S2) of classifying data bit sequences obtained in the step of performing simulation and running on the bus into at least one bit sequence having a meaning according to a protocol of the bus, and of storing the bit sequences as transaction data (60), and
   a step (S3, S4) of analyzing the transaction data, and of generating a control portion (4) for controlling the bus based on a predetermined condition.

2. The method for designing a semiconductor integrated device according to claim 1,
   wherein in the step of storing transaction data, a transaction storage portion (5) for extracting and storing the data bit sequences running on the bus according to the protocol as the transaction data is realized as hardware on the bus.

3. The method for designing a semiconductor integrated device according to claim 1,
   wherein in the step of storing transaction data, a transaction storage portion for extracting and storing the data bit sequences running on the bus according to the protocol as the transaction data is realized as software that is executed by a central processing unit (1) connected on the bus.

4. The method for designing a semiconductor integrated device according to claim 1,
   wherein the step of generating a control portion includes the step of:

generating the control portion for determining a bus width of the bus based on the transaction data, and

setting a selector (7) for selecting the bus width.

5. The method for designing a semiconductor integrated device according to claim 1,

wherein the step of generating a control portion includes the step of:

generating the control portion for dynamically determining a bus width of the bus according to characteristics of the transaction data, and setting a selector for selecting the bus width.

6. The method for designing a semiconductor integrated device according to claim 1,

wherein in the step of generating a control portion, the control portion is generated to control the bus in such a manner that:

a bit string having a smallest change for each bit between sequential fixed-length bit strings in the transaction data is selected,

the selected bit string in the transaction data is converted so as to minimize the change for each bit, and

information for reconstructing the bit string before the conversion from the converted bit string is added.

7. The method for designing a semiconductor integrated device according to claim 1,

wherein in the step of generating a control portion, the control portion is generated to control the bus in such a manner that:

a bit string having a smallest change for each bit between sequential variable-length bit strings in the transaction data and a length of this bit string are selected,

the selected bit string in the transaction data is converted with the length of the bit string so as to minimize the change for each bit, and

information for reconstructing the bit string before the conversion from the converted bit string is added.

8. The method for designing a semiconductor integrated device according to claim 7,

wherein the control portion dynamically changes the length of the bit string according to characteristics of the transaction data.

9. The method for designing a semiconductor integrated device according to claim 1,

wherein in the step of generating a control portion, the control portion is generated to control the bus in such a manner that:

an appearance rate of each type of the transaction data is measured,

a conversion table is created that converts a bit string in the transaction data whose appearance rate is comparatively high into a bit string smaller than the bit string is created, and

the bit string in the transaction data is converted based on the conversion table.

10. The method for designing a semiconductor integrated device according to claim 9,

wherein the control portion dynamically changes the conversion table according to characteristics of the transaction data.

11. The method for designing a semiconductor integrated device according to claim 10,

wherein the conversion table is implemented as software executed by the central processing unit connected on the bus, and

wherein the conversion table is dynamically changed by the software.

12. The method for designing a semiconductor integrated device according to claim 1,

wherein in the step of generating a control portion, the control portion is generated to control the bus in such a manner that the transaction data is transmitted via a memory device (13) having an input bus width and an output bus width that are different from each other, according to the transaction data.

13. The method for designing a semiconductor integrated device according to claim 12,

wherein the control portion dynamically changes at least one of the input bus width and the output bus width according to characteristics of the transaction data.

14. The method for designing a semiconductor integrated device according to claim 1,

wherein in the step of generating a control portion, the control portion is generated to control the bus in such a manner that according to characteristics of the transaction data, a frequency dividing circuit is controlled to dynamically change an operation frequency.

15. A program for designing a semiconductor integrated device with which a semiconductor integrated device having a bus connecting between functional blocks is designed and that is executed by a computer,

wherein the program lets the computer execute:

a step of performing simulation that simulates an operation of the semiconductor integrated device,

a step of classifying data bit sequences obtained in the step of performing simulation and running on the bus into at least one bit sequence having a meaning according to a protocol of the bus, and of storing the bit sequences as transaction data, and

a step of analyzing the transaction data, and of generating a control portion for controlling the bus based on a predetermined condition.

16. A storage medium for storing a program for designing a semiconductor integrated device with which a semiconductor integrated device having a bus connecting between functional blocks is designed and that is executed by a computer,

wherein the program lets the computer execute:

a step of performing simulation that simulates an operation of the semiconductor integrated device

a step of classifying data bit sequences obtained in the step of performing simulation and running on the bus into at least one bit sequence having a meaning according to a protocol of the bus, and of storing the bit sequences as transaction data, and

a step of analyzing the transaction data, and of generating a control portion for controlling the bus based on a predetermined condition.

FIG. 1

START BUS ANALYSIS AND OPTIMIZATION PROCESS

S1 — SIMULATION PROCESS

S2 — TRANSACTION DATA STORAGE PROCESS

S3 — TRANSACTION DATA ANALYSIS PROCESS

S4 — CONTROL PORTION GENERATION PROCESS

END

F I G. 2

F I G. 3

SOFTWARE 50

CPU 1

CONTROL PORTION 4

TRANSACTION DATA 60

HARDWARE 3

MEMORY 2

TRANSACTION STORAGE PORTION 5

EP 1 607 886 A2

FIG. 4

EP 1 607 886 A2

FIG. 5A

DATA SIZE B

d32

TIME t

FIG. 5B

ELECTRIC POWER P

TIME t

FIG. 5C

DATA SIZE B

d8a   d8b   d8c   d8d

TIME t

FIG. 5D

ELECTRIC POWER P

TIME t

EP 1 607 886 A2

F I G. 7

4m

MASTER CONTROL
PORTION

MASTER
SELECTOR

L

MASTER BUFFER

6m          7m

F I G. 8

4m
MASTER CONTROL
PORTION

4s
SLAVE CONTROL
PORTION

Sg1

MASTER DATA
CONVERSION
CIRCUIT

8m

SLAVE DATA
RECONSTITUTION
CIRCUIT

9s

EP 1 607 886 A2

F I G. 9

MASTER CONTROL
PORTION — 4m

Sg1a

Sg1a

MASTER BIT
INVERSION
CIRCUIT — 8ma

MASTER BIT
INVERSION
CIRCUIT — 9sa

F I G.  1 0 A

| T1 | T2 | TOGGLE COUNT |
|---|---|---|

0100 0001 1110 0000 ⟶ 1011 1110 0001 1110  – – – – – ➤ 15

↓ BIT INVERSION

0100 0001 1110 0001  – – – – – ➤ 1

F I G.  1 0 B

| T3 | T4 | TOGGLE COUNT |
|---|---|---|

0100 0001 1110 0000 ⟶ 0111 0101 0010 0101  – – – – – ➤ 7

↓ BIT INVERSION

1000 1010 1101 1010  – – – – – ➤ 9

EP 1 607 886 A2

EP 1 607 886 A2

F I G.  1 1 A

```
         T5                              T6                    TOGGLE COUNT
 ┌────────────────┐              ┌────────────────┐
  0100 0001 1110 0000    ──────►   1011 1110 1110 0000   ── ── ── ►  8
                                           │ BIT INVERSION
                                           ▼
                                  0100 0001 0001 1111   ── ── ── ►  8
```

F I G.  1 1 B

```
         T5                              T6                    TOGGLE COUNT
 ┌────────────────┐              ┌────────────────┐
  0100 0001 1110 0000    ──────►   1011 1110 1110 0000   ── ── ── ►  8
 └────────┴───────┘              └────────┴───────┘
  8 BITS    8 BITS         BIT         │         │ NOT PERFORM BIT INVERSION
                           INVERSION ▼         ▼

                                  0100 0001 1110 0000   ── ── ── ►  0
```

EP 1 607 886 A2

F I G. 1 3

| TRANSACTION DATA T | APPEARANCE RATE | CODE TO BE ALLOCATED |
|---|---|---|
| 00 | 80% | 0 |
| 01 | 13% | 01 |
| 10 | 5% | 001 |
| 11 | 2% | 000 |

EP 1 607 886 A2

F I G. 1 4

```
        12m                                    12s
         │                                      │
    ┌────────────────┐                    ┌────────────────┐
──▶ │ MASTER MEMORY  │ ─────────────────▶ │ SLAVE MEMORY   │ ──▶
    │ CONTROL PORTION│                    │ CONTROL PORTION│
    └────────────────┘                    └────────────────┘
         │                                      ▲
    BW1  │                                 BW2  │
         ▼                                      │
    ┌──────────────────────────────────────────────┐
    │              MEMORY PORTION                    │
    └──────────────────────────────────────────────┘
                         │
                        13
```

EP 1 607 886 A2

FIG. 15

MASTER CLOCK
CONTROL PORTION
14m

Sg3

Sg4

MASTER DATA
SENDING CIRCUIT
15m

SLAVE DATA
RECEIVING
CIRCUIT
16s

EP 1 607 886 A2

F I G. 1 6

14m

Sg3

Sg5

COUNTER 141m

Sg6

Sg4

EP 1 607 886 A2

F I G. 1 7

EP 1 607 886 A2

F I G. 1 8